## Europäisches Patentamt

## European Patent Office

## Office européen des brevets

(19)

(11) Veröffentlichungsnummer: **0 103 068**
**B1**

(12) # EUROPÄISCHE PATENTSCHRIFT

(45) Veröffentlichungstag der Patentschrift:
04.01.89

(51) Int. Cl.⁴: **H 01 L 23/40,** H 01 L 23/32

(21) Anmeldenummer: **83104872.3**

(22) Anmeldetag: **17.05.83**

(54) Einrichtung zum Kühlen einer Mehrzahl von zu Flachbaugruppen zusammengefassten integrierten Bausteinen.

(30) Priorität: **09.09.82 DE 3233491**

(43) Veröffentlichungstag der Anmeldung:
**21.03.84 Patentblatt 84/12**

(45) Bekanntmachung des Hinweises auf die Patenterteilung:
**04.01.89 Patentblatt 89/1**

(84) Benannte Vertragsstaaten:
**AT BE CH DE FR GB IT LI NL**

(56) Entgegenhaltungen:
**EP-A-0 000 244**

**PATENTS ABSTRACTS OF JAPAN, Band 6, Nr. 151
(E-124) 1029 , 11 August 1982
IBM TECHNICAL DISCLOSURE BULLETIN, Band 21,
Nr. 3, August 1978, Seiten 1064-1065, Armonk, New
York, US; R.D. DURAND et al.: "Ceramic cap and
heat sink for semiconductor package"
IBM TECHNICAL DISCLOSURE BULLETIN, Band 8,
Nr. 3, August 1965, Seite 380, Armonk, New York,
US; L.F. MILLER: "Microelectronic device
standoffs"
PATENTS ABSTRACTS OF JAPAN, Band 8, Nr. 66 (E-
234) 1503 , 28. März 1984**

(73) Patentinhaber: **Siemens Aktiengesellschaft Berlin
und München, Wittelsbacherplatz 2, D-8000
München 2 (DE)**

(72) Erfinder: **Wessely, Herrmann, Dipl.- Ing., Paul-
Hösch- Strasse 1, D-8000 München 60 (DE)**

EP 0 103 068 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf eine Einrichtung zum Kühlen einer Mehrzahl von zu Flachbaugruppen zusammengefaßten integrierten Bausteinen gemäß dem Oberbegriff des Anspruchs 1.

Eine solche Einrichtung ist z. B. aus dem Patent Abstracts of Japan, Band 6, Nr 151 (E-124) [1029], 11 August 1982, bekannt.

Die zunehmende Miniaturisierung von integrierten Bausteinen zu sogenannten hochintegrierten Bausteinen und in Verbindung damit die hohe Packungsdichte haben eine starke Wärmeabgabe derjenigen Flachbaugruppen zur Folge, die mit einer Mehrzahl solcher integrierter Bausteine bestückt sind, was leicht zu einer Überschreitung der für die integrierten Bausteine zulässigen Temperaturen führen kann. Zu ihrem Schutz werden deshalb derartige Flachbaugruppen mit einem oder auch mehreren Kühlkörpern versehen.

Es ist bekannt, für derartige Flachbaugruppen großflächige Metallplatten als Kühlkörper zu verwenden, die die Abwärme der integrierten Bausteine entweder an die sie umgebende Luft oder an flüssigkeits- oder gasdurchströmte Hohlkörper abgeben. So ist z. B. aus dem US-Patent 3 993 123 eine Einrichtung mit einer Mehrzahl von wärmeerzeugenden elektrischen Bausteinen bekannt, die auf einer Unterlage montiert sind. Ein Wärmeableitgehäuse versiegelt und umschließt die wärmeerzeugenden Bauelemente. Die der Unterlage gegenüberliegende Wand des Gehäuses besitzt langgestreckte zylinderförmige Öffnungen in Richtung auf die wärmeerzeugenden Bauelemente zu. In jeder derartigen Öffnung des Gehäuses befindet sich ein Federelement, das sich gegen das innere Ende der Öffnung abstützt. Außerdem befindet sich in jeder Öffnung ein wärmeleitendes Element in Form eines Kolbens, der so dimensioniert ist, daß nur ein schmaler Spalt zwischen den äußerden Wänden der Öffnungen und dem Kolben bleibt. Jedes Federelement drückt das Wärmeleitelement gegen eines der wärmeerzeugenden Bauelemente.Ein wärmeleitendes inertes Fluidum befindet sich im Inneren des Gehäuses und füllt alle Spalte und Leerräume desselben aus. Die Wärme wird von dem Gehäuse durch externe Ableitmittel abgeleitet. Durch derartige Maßnahmen oder durch Maßnahmen, wie sie aus der europäischen Patentanmeldung 0 001 153 als Weiterbildung dieser allgemeinen Idee bekannt sind, wird jeder einzelne elektronische Baustein individuell gekühlt. Nachteilig bei dieser Art von Kühleinrichtung ist jedoch, daß die Wärme von dem Chip des integrierten Bausteines nur über punktformige Kontakte in den Stempel und von dort über eine Gasstrecke in den eigentlichen Kühlkörper fließt. Der punktförmige Kontakt zwischen integriertem Baustein und Metallstempel und die Gasstrecke zwischen Metallstempel und Kühlkörper haben einen relativ hohen Wärmewiderstand. Außerdem erfordert der Aufbau einen großen Aufwand.

Der vorliegenden Erfindung lag daher die Aufgabe zugrunde, eine Einrichtung zum Kühlen derartiger integrierter Bausteine zu schaffen, die zum einen einen wesentlich geringeren Wärmewiderstand besitzt und deshalb eine deutlich bessere Kühlung der integrierten Bausteine mit sich bringt und die außerdem einen wesentlich geringeren Aufwand erfordert. Erfindungsgemäß wird dies dadurch erreicht, daß der Andruck der einzelnen integrierten Bausteine an die gemeinsame Kühlplatte durch jeweils zwischen starrer Leiterplatte und integriertem Baustein eingefügte federnde Elemente erfolgt. Durch Zwischenfügen von Leitfett zwischen die integrierten Bausteine einerseits und die Kühlplatte andererseits kann der Wärmewiderstand der Einrichtung weiter gesenkt werden.

Weitere Ausgestaltungen der erfindungsgemäßen Einrichtungen ergeben sich aus den Unteransprüchen sowie aus der nachfolgenden Beschreibung von vorteilhaften Ausführungsbeispielen der erfindungsgemäßen Einrichtung anhand der Figuren.

FIG. 1   zeigt den prinzipiellen Aufßau einer erfindungsgemäßen Kühleinrichtung,

FIG. 2   zeigt die Anordnung eines federnden Füllstücks zwischen integriertem Baustein und starrer Leiterplatte,

FIG. 3   zeigt die Anordnung eines starren Abstandsstückes zwischen integriertem Baustein und starrer Leiterplatte.

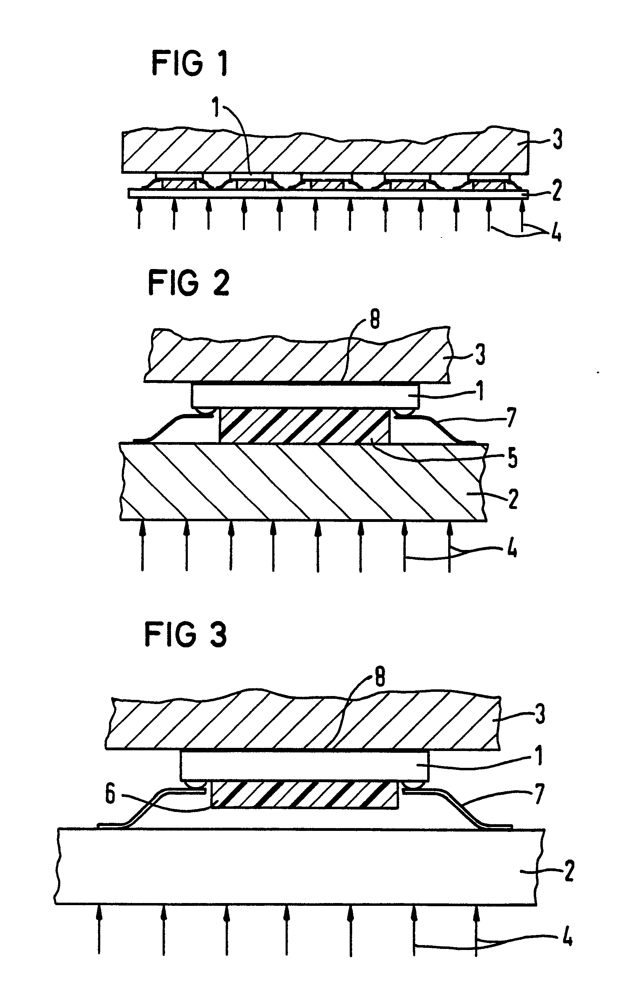

FIG 1 zeigt eine Mehrzahl von integrierten Bausteinen 1, die auf einer starren Leiterplatte 2 zu einer Flachbaugruppe zusammengefaßt sind. Weiterhin ist ersichtlich, daß die integrierten Bausteine 1, die gehäuselos sind, auf ihrer gesamten Rückfläche mit einer allen integrierten Bausteinen gemeinsamen Kühlplatte 3 in Kontakt stehen. Diese gemeinsame Kühlplatte 3 ist von sehr hoher Ebenheit. Durch einen flächig wirkenden Andruck 4, z. B. in Form einer Vielzahl von Federn oder eines gasförmigen Mediums, wird die starre Leiterplatte 2 zusammen mit den integrierten Bausteinen 1 gegen die gemeinsame Kühlplatte 3 mit großer Ebenheit gedrückt. Mit einer starren Leiterplatte 2 allein ist jedoch ein optimales Andrücken der einzelnen integrierten Bausteine 1 nicht gewährleistet. Um dies zu erreichen, wird die Andruckkraft für die einzelnen integrierten Bausteine 1 individuell verteilt, indem jeweils zwischen starrer Leiterplatte 2 und integriertem Baustein 1 individuelle federnde Elemente angeordnet sind.

FIG. 2 zeigt ein mögliches Ausführungsbeispiel für derartige federnde Elemente, hier in Form eines federnden Füllstückes 5 zwischen integriertem Baustein 1 und starrer Leiterplatte 2. Das federnde Füllstück 5 besteht vorteilhafterweise aus Gummi, und die Anschlüsse 7 der integrierten Bausteine 1 sind so ausgebildet, daß sie keine Kräfte aufnehmen können. Die federnden Füllstücke 5 bewirken, daß die auf die starre Leiterplatte flächig ausgeübte Kraft 4 jedem einzelnen integrierten Baustein individuell zugeführt wird und somit jeden integrierten Baustein sicher an die gemeinsame Kühlplatte 3 andrückt.

Ein anderes Ausführungsbeispiel der erfindungsgemäßen Einrichtung zeigt FIG. 3. Dieses unterscheidet sich von dem Ausführungsbeispiel in FIG. 2 dadurch, daß die Anschlüsse 7 der integrierten Bausteine 1 so ausgebildet sind, daß sie beim Andrücken der starren Leiterplatte 2 gegen die Kühlplatte 3 als Federelemente wirken. Außerdem ist zwischen jedem integrierten Baustein 1 und der starren Leiterplatte 2 ein starres Abstandsstück 6 vorgesehen, welches zur Begrenzung des Federweges dient.

Um den an sich schon sehr geringen Wärmewiderstand der erfindungsgemäßen Einrichtung weiter zu verringern, ist es vorteilhaft, zwischen die integrierten Bausteine 1 und die gemeinsame Kühlplatte 3 jeweils Leitfett 8 einzufügen.

Die integrierten Bausteine 1 sind auf der Leiterplatte 2 in sogenannter Micropack-Anschlußtechnik kontaktiert.

## Patentansprüche

1. Einrichtung zum Kühlen einer Mehrzahl von zu Flachbaugruppen zusammengefaßten gehäuselosen integrierten Bausteinen, die auf einer starren Leiterplatte angeordnet sind, wobei die gesamte Rückfläche jedes integrierten Bausteins in Kontakt mit einer allen integrierten Bausteinen gemeinsamen ebenen Kühlplatte ist, dadurch gekennzeichnet, daß der Andruck der einzelnen integrierten Bausteine (1) an die gemeinsame Kühlplatte (3) durch jeweils zwischen starrer Leiterplatte (2) und integriertem Baustein (1) eingefügte federnde Elemente (5, 7) erfolgt.

2. Einrichtung nach Anspruch 1, dadurch gekennzeichnet, daß zwischen jedem integriertem Baustein (1) und der starren Leiterplatte (2) ein federndes Füllstück (5) angeordnet ist.

3. Einrichtung nach Anspruch 2, dadurchgekennzeichnet, daß das federnde Füllstück (5) aus Gummi besteth.

4. Einrichtung nach einem der Ansprüche 1 bis 3, dadurch gekennzeichnet, daß die Anschlüsse (7) der integrierten Bausteine (1) so ausgebildet sind, daß sie keine Kräfte aufnehmen können.

5. Einrichtung nach einen der Ansprüche 1 bis 3, dadurch gekennzeichnet, daß die Anschlüsse (7) der integrierten Bausteine (1) so ausgebildet sind, daß sie beim Andrücken der Leiterplatten (2) gegen die Kühlplatte (3) als Federelemente wirken.

6. Einrichtung nach Anspruch 5, dadurch gekennzeichnet, daß zwischen jedem integriertem Baustein (1) und der starren Leiterplatte (2) ein starres Abstandsstück (6) zum Begrenzen des Federweges vorgesehen ist.

7. Einrichtung nach einem der Ansprüche 1 bis 6, dadurch gekennzeichnet, daß zwischen den integrierten Bausteinen (1) und der Kühlplatte (3) Leitfett (8) angeordnet ist.

## Claims

1. Cooling device for a plurality of integrated components without housing assembled as a flat structure which are arranged on a rigid circuit board, the entire rear surface of each integrated component being in contact with a plane cooling plate common to all integrated components, characterized in that the individual integrated components (1) are pressed against the common cooling plate (3) in each case by spring elements (5, 7) inserted between rigid circuit board (2) and integrated component (1).

2. Device according to Claim 1, characterized in that a spring filler piece (5) is arranged between each integrated component (1) and the rigid circuit board (2).

3. Device according to Claim 2, characterized in that the spring filler piece (5) is made of rubber.

4. Device according to one of Claims 1 to 3, characterized in that the connections (7) of the integrated components (1) are designed so that they cannot absorb any forces.

5. Device according to one of Claims 1 to 3, characterized in that the connections (7) of the integrated components (1) are designed so that they act as spring elements when the circuit boards (2) are pressed against the cooling plate (3).

6. Device according to Claim 5, characterized in that a rigid spacer piece (6) to limit the spring excursion is provided between each integrated component (1) and the rigid circuit board (2).

7. Device according to one of Claims 1 to 6, characterized in that conductive grease (8) is arranged between the integrated components (1) and the cooling plate (3).

## Revendications

1. Dispositif pour refroidir un certain nombre de composants intégrés rassemblés sans boîtiers en modules plats, les composants étant disposés sur une carte imprimée rigide et toute la face arrière de chaque composant étant en contact avec une plaque de refroidissement plane, commune à tous les composants intégrés, caractérisé en ce que les différents composants intégrés (1) sont pressés contre la plaque de refroidissement (3) commune par des éléments élastiques (5, 7) disposés chacun entre la carte imprimée rigide (2) et un composant intégré (1).

2. Dispositif selon la revendication 1, caractérisé en ce qu'une pièce de remplissage élastique (5) est placée entre chaque composant intégré (1) et la carte imprimée rigide (2).

3. Dispositif selon la revendication 2, caractérisé en ce que la pièce de remplissage élastique (5) est en caoutchouc.

4. Dispositif selon une des revendications 1 à 3, caractérisé en ce que les connexions (7) des composants intégrés (1) sont réalisées de manière qu'elle ne puissent pas absorber des forces.

5. Dispositif selon une des revendications 1 à 3, caractérisé en ce que les connexions (7) des composants intégrés (1) sont réalisées de manière qu'elles agissent comme des éléments élastiques lorsque les cartes imprimées (2) sont pressées contre la plaque de refroidissement (3).

6. Dispositif selon la revendication 5, caractérisé en ce qu'une pièce d'espacement rigide (6) est disposée entre chaque composant intégré (1) et la carte imprimée rigide (2) pour limiter la course élastique.

7. Dispositif selon une des revendications 1 à 6, caractérisé en ce que de la graisse conductrice (8) est disposée entre les composants intégrés (1) et la plaque de refroidissement (3).

## FIG 1

## FIG 2

## FIG 3